(19) Europäisches Patentamt / European Patent Office / Office européen des brevets

(11) **EP 3 923 435 B1**

(12) **EUROPÄISCHE PATENTSCHRIFT**

(45) Veröffentlichungstag und Bekanntmachung des Hinweises auf die Patenterteilung:
**19.03.2025   Patentblatt 2025/12**

(21) Anmeldenummer: **20179320.5**

(22) Anmeldetag: **10.06.2020**

(51) Internationale Patentklassifikation (IPC):
**H02H 9/08** $^{(2006.01)}$      **H02J 3/18** $^{(2006.01)}$

(52) Gemeinsame Patentklassifikation (CPC):
**H02H 9/08; H02J 3/18;** Y02E 40/30

(54) **VERFAHREN UND EINE VORRICHTUNG ZUR ÜBERWACHUNG EINES KOMPENSIERT BETRIEBENEN DREHSTROMNETZES AUF EINE ABSTIMMUNGSÄNDERUNG DER ERDSCHLUSSLÖSCHSPULE**

METHOD AND DEVICE FOR MONITORING A COMPENSATED THREE-PHASE CURRENT NETWORK FOR A CHANGE IN THE TUNING OF THE ARC SUPPRESSION COIL

PROCÉDÉ ET DISPOSITIF DE SURVEILLANCE D'UN RÉSEAU TRIPHASÉ À FONCTIONNEMENT COMPENSÉ AU NIVEAU D'UNE VARIATION DE SYNTONISATION DE LA BOBINE D'EXTINCTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**15.12.2021   Patentblatt 2021/50**

(73) Patentinhaber: **HSP Hochspannungsgeräte GmbH 53842 Troisdorf (DE)**

(72) Erfinder:
• **Schinerl, Thomas 4063 Hörsching (AT)**
• **Aigner, Markus 4651 Stadl-Paura (AT)**
• **Schuster, Hannes 4614 Marchtrenk (AT)**

(74) Vertreter: **Betten & Resch Patent- und Rechtsanwälte PartGmbB Maximiliansplatz 14 80333 München (DE)**

(56) Entgegenhaltungen:
WO-A2-96/34293          WO-A2-99/10959
DE-A1- 102008 016 136   DE-A1- 2 017 867
DE-A1- 3 643 391

**Beschreibung**

Die Erfindung betrifft ein Verfahren und eine Vorrichtung zur Überwachung eines kompensiert betriebenen Drehstromnetzes auf eine Abstimmungsänderung der Erdschlusslöschspule.

In kompensierten Netzen wird eine Erdschlusslöschspule (Petersen Spule) dazu verwendet, kapazitive Erdfehlerströme von Abgängen mit einem induktiven Strom zu kompensieren.

Sofern der induktive Strom durch die Erdschlusslöschspule genau den kapazitiven Nullströmen der Abgänge entspricht (Resonanzabstimmung), ist der verbleibende netzfrequente Fehlerstrom minimal und wird durch die Wirkverluste im Netz bestimmt.

In der Praxis wird oftmals eine geringfügige Unter- oder Überkompensation eingestellt, wobei es aber sichergestellt sein muss, dass bei den gegebenen Erdungsverhältnissen und dem verbleibenden Fehlerstrom an der Fehlerstelle die auftretende Schrittspannung die zulässigen Grenzen und die zulässige Zeitdauer nicht überschritten wird.

Daher ist es sehr wichtig, Änderungen in der Netzkonfiguration beziehungsweise Änderungen der Verstimmung automatisch und zuverlässig zu erkennen, damit eine neue Ermittlung der Netzparameter angestoßen wird und damit ein neuer Abstimmpunkt für die Erdschlusslöschspule ermittelt und die Erdschlusslöschspule entsprechend in einem Abstimmvorgang abgestimmt werden kann.

Bekannte Verfahren nützen die Tatsache aus, dass bei realen Drehstromnetzen stets eine gewisse Asymmetrie der einzelnen Phasen vorliegt, sodass im Sternpunkt, das heißt auch an der Erdschlusslöschspule, eine bestimmte Verlagerungsspannung auftritt, aber auch bei sehr symmetrischen Netzen kann durch Zuschaltung einer künstlichen Asymmetrie in zumindest einer Phase oder auch durch Einspeisen eines netzfrequenten Stromes in den Sternpunkt des Transformators eine ausreichend hohe Verlagerungsspannung im Abstimmpunkt der Erdschlusslöschspule erreicht werden und eine Änderung der Netzverstimmung kann dann anhand einer signifikanten Änderung der Sternpunkt-Verlagerungsspannung erkannt werden.

Neuerliche Abstimmvorgänge erfordern jeweils eine Neubestimmung von Netzparametern, welche in der Regel aufwändig ist und deren Anzahl möglichst klein gehalten werden soll.

Netzparameter für ein Dreiphasennetz können durch Bestimmen der Netzparameter mittels netzfrequenter Stromeinspeisung, oder mittels Mehrfrequenzverfahren oder nicht netzfrequenter Stromeinspeisung, oder auch durch Spulenverstellung (wie bei Tauchkernspulen) beziehungsweise Änderung des Verstimmungsgrades (bei Stufenspulen) ermittelt werden.

Es ist bekannt, dass schnelle Änderungen der Verlagerungsspannungen auch ohne Änderungen der Netzkonfiguration, wie beispielsweise durch starke Laststromschwankungen, kapazitive Einkopplungen oder aber auch durch kurzzeitige Schwankungen der Netzfrequenz erfolgen können.

Insbesondere bei der Bestimmung der Netzparameter durch Spulenverstellung beziehungsweise Änderung des Verstimmungsgrades (Stufenspulen) sollten zu häufige Abstimmvorgänge vermieden werden, da sich das negativ auf die Lebensdauer der Erdschlusslöschspule auswirken kann.

Bisherige bekannte Verfahren sichern direkt nach Abstimmung der Erdschlusslöschspule die Verlagerungsspannung als Referenzgröße. Dann wird die Verlagerungsspannung auf Änderungen überwacht, eventuell kommen noch zusätzliche Filter zur Anwendung. Ein solches Verfahren ist beispielsweise in der DE 36 43 391 A1 beschrieben.

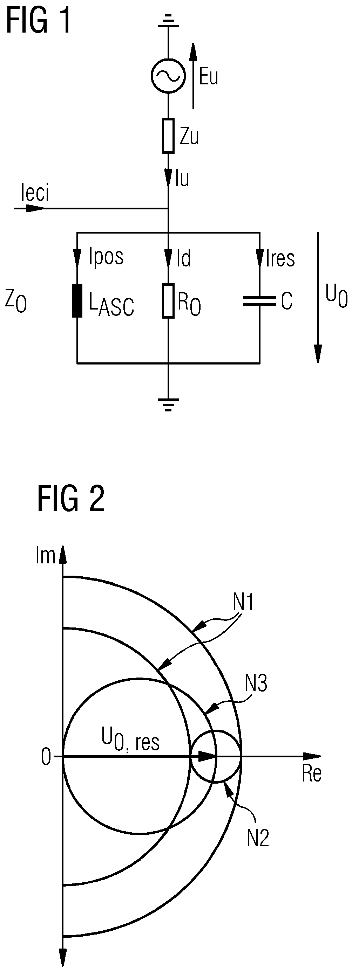

Sofern durch Änderung der Verlagerungsspannung der Auslösekreis (vektorielle Messung der Verlagerungsspannung) verlassen wird, wird eine Auslöseverzögerung gestartet. In Fig. 2 ist ein Auslösekreis N2 für eine "vektorielle Auslösung" erkennbar. Sofern die Verlagerungsspannung wieder innerhalb des Auslösekreises liegt, wird die Auslöseverzögerung zurückgesetzt. Nach Ablauf der Auslöseverzögerung kann ein neuer Abstimmvorgang erfolgen.

Zu häufige Auslösungen von Abstimmvorgängen durch Änderungen der Verlagerungsspannung aufgrund von Netzfrequenzschwankungen können bei derzeit bekannten Systemen nur durch entsprechend lange Auslöseverzögerungen beziehungsweise großen zulässige Änderungen der Verlagerungsspannung vermieden werden, damit steigt unter Umständen die Zeitdauer, wo der Kompensationsgrad der Erdschlusslöschspule nicht der gewünschten Einstellung entspricht, an bzw. können kleinere Änderung des Verstimmungsgrades des Netzes nicht mehr zuverlässig erkannt werden.

Bei der Anwendung der Erdschlusslöschspule in Kombination mit der aktiven Reststromkompensation wird im Erdschlussfall ein Kompensationsstrom eingespeist, der dem Fehlerstrom entgegenwirkt.

Ein Fehlerwirkstrom kann durch Netzverluste und einen Fehlerblindstrom verursacht werden, wobei der Fehlerblindstrom durch eine Netzverstimmung bei der aktuellen Netzfrequenz hervorgerufen wird.

Damit im Erdschlussfall die vollständige Kompensation des Fehlerstromes gewährleistet ist, muss auf Änderungen der Verstimmung des Netzes sowie auf Änderung der Dämpfung oder auch Änderung der Asymmetrie rasch reagiert werden. Die Netzparameter müssen neu ermittelt werden und die Erdschlusslöschspule muss zumindest bei größeren Verstimmungsänderungen bezogen auf die Nominalfrequenz neu abgestimmt werden, da die verwendeten Umrichter zur Reststromkompensation nur eine begrenzte Leistung haben und nicht beliebig große Blindströme kompensieren können. Der Großteil der Kompensation des Blindstromanteils im Fehlerstrom erfolgt auch während der Reutst-

romkompensation durch die Erdschlusslöschspule. Andererseits sind häufige Auslösungen von Abstimmvorgängen unerwünscht, da während der Berechnung der Netzparameter die Empfindlichkeit reduziert werden muss und das Ansprechen der Reststromkompensation verzögert werden kann.

Es ist daher eine Aufgabe der Erfindung, Änderungen der Netzkonfiguration und damit Änderungen der Netzverstimmung und auch im Fall von Netzfrequenzänderungen mit Hilfe einer kurzen Auslöseverzögerung und kleinen Auslöseschwellen robust und sicher zu erkennen.

Die Aufgabe wird durch ein Verfahren und eine Vorrichtung eingangs genannter Art gelöst, indem für einen abgestimmten Zustand Referenz-Netzparameter und eine Referenz-Netzfrequenz ermittelt werden, und für einen aktuellen Zustand eine aktuelle Netzfrequenz ermittelt wird, und eine Referenz-Kenngröße, welche zu einer Verlagerungsspannung proportional ist, mithilfe der Referenz-Netzparameter für die aktuelle Netzfrequenz bestimmt wird, und eine aktuelle Kenngröße, welche zu einer Verlagerungsspannung proportional ist, bei der aktuellen Netzfrequenz bestimmt wird, und eine Differenz-Größe aus der Referenz-Kenngröße und der aktuellen Kenngröße bestimmt wird, aus welcher bei Überschreiten eines vorbestimmten Grenzwerts eine Abstimmungsänderung erkannt wird und geänderte Netzparameter ermittelt werden.

Durch die Erfindung kann erreicht werden, dass ein Auslösekriterium mit kurzer Auslöseverzögerung zur Durchführung einer erneuten Kompensation angewandt wird, welches sehr robust gegen Fehlauslösungen aufgrund von Frequenzschwankungen ist.

In einer Weiterbildung der Erfindung ist es vorgesehen, dass die Referenz-Kenngröße und die aktuelle Kenngröße jeweils eine Verlagerungsspannung sind.

Dadurch kann das erfindungsgemäße Verfahren besonders einfach implementiert werden.

In einer Weiterbildung der Erfindung ist es vorgesehen, dass für die Differenz-Größe der Betrag einer vektoriellen Differenz herangezogen wird.

Dadurch kann das erfindungsgemäße Verfahren besonders einfach implementiert werden.

In einer Weiterbildung der Erfindung ist es vorgesehen, dass die Bestimmung der geänderten Netzparameter zeitverzögert erfolgt, falls die Differenz-Größe über einen vorbestimmten Zeitraum hinweg durchgehend den vorbestimmten Grenzwert überschreitet.

Dadurch kann das erfindungsgemäße Verfahren besonders robust und störungsunabhängig ausgeführt werden.

In einer Weiterbildung der Erfindung ist es vorgesehen, dass die Netzparameter zumindest eine Induktivität der Erdschlusslöschspule und zumindest eine Leitungskapazität umfassen.

Dadurch kann das erfindungsgemäße Verfahren besonders einfach implementiert werden.

Die erfindungsgemäße Vorrichtung zur Überwachung eines kompensiert betriebenen Drehstromnetzes auf eine Abstimmungsänderung der Erdschlusslöschspule umfasst eine Messvorrichtung zur Erfassung einer Verlagerungsspannung und einer Netzfrequenz, eine Rechenvorrichtung zur Bestimmung von Netzparametern, wobei die Vorrichtung dazu eingerichtet ist, das erfindungsgemäße Verfahren auszuführen.

Die Erfindung wird nachfolgend anhand eines in den beigeschlossenen Zeichnungen dargestellten Ausführungsbeispiels näher erläutert. In den Zeichnungen zeigt:

Fig. 1 ein vereinfachtes Nullersatzschaltbild eines Drei-Phasensystems,

Fig. 2 Beispiele für Ortskurven von Verlagerungsspannungen und Auslöseschwellen bei der Überwachung einer Sternpunktspannung,

Fig. 3-4 Beispiele für den Frequenzverlauf eines Dreiphasennetzes über die Zeit,

Fig. 5-7 Beispiele für Ortskurven eines Dreiphasennetzes.

**Fig. 1** zeigt ein Beispiel für ein vereinfachten NullErsatzschaltbild eines Drehstromnetzes.

Es ist eine Netz-Asymmetrie dargestellt, welche hauptsächlich durch unterschiedliche Leiter - Erde Kapazitäten der drei Phasen gebildet wird. Im Nullersatzschaltbild wird der diese Unsymmetrie darstellende Unsymmetrie-Strom $I_u$ über die treibende Unsymmetrie-Spannung $E_u$ und der Unsymmetrie-Impedanz $Z_u$ dargestellt.

Zur Kompensation des kapazitiven Fehler-Stroms $I_f$ aufgrund des Erdschlusses ist der Sternpunkt des Netzes mittels einer Erdschlusslöschspule $L_{ASC}$ (engl. "arc suppression coil") (Petersen-Spule) geerdet.

Die im Ersatzschaltbild eingezeichnete Netzimpedanz $Z_0$ wird durch die Parallelschaltung eines ohmschen Ersatzwiderstands $R_0$ für die gesamte Netzverluste, inklusive der Verluste der Erdschlusslöschspule, der Netzkapazität $C$ (Leitungskapazität) und der Induktivität $L_{ASC}$ der Erdschlusslöschspule gebildet.

Der Ersatzwiderstand $R_0$ bestimmt einen Dämpfungsstrom $I_D$.

Die Impedanz der Erdschlusslöschspule $L_{ASC}$ und damit die Höhe eines induktiven Kompensationsstromes kann direkt durch Verstellen des Luftspaltes im Eisenkreis der Erdschlusslöschspule verändert werden, oder die Sekundärseite der Erdschlusslöschspule $L_{ASC}$ wird mit einer Induktivität, einem Kondensator oder einer definierten Stromeinspeisung beschaltet, und/oder es kann der Sternpunkt oder eine der drei Phasen mit einem ohmschen Widerstand, einer Induktivität, einem Kondensator oder einer definierten Stromeinspeisung beschaltet werden. Derartige Maßnahmen bzw. Einrichtungen sind dem Fachmann bekannt, sodass sie nicht naher erläutert oder dargestellt werden müssen.

Die Spulenposition kann über eine Positionsmessung mittels Potentiometer ermittelt werden. Daraus resultiert ein Spulenstrom $I_{pos}$.

Die Abstimmung der Erdschlusslöschspule $L_{ASC}$ erfolgt im Normalbetrieb des Netzes (fehlerfreier Netzzustand), wobei die Erdschlusslöschspule $L_{ASC}$ so eingestellt wird, dass der induktive Strom durch die Erdschlusslöschspule $L_{ASC}$ dem kapazitiven Strom über die Netzkapazität (Resonanz-Strom $I_{res}$) entspricht.

In der Praxis kann für ein gelöschtes Netz, jedoch ohne aktive Reststromkompensation im Normalbetrieb, eine geringe Überkompensation bzw. Unterkompensation eingestellt sein. Dies kann durch Einstellung eines Stromes $I_{pos}$ erfolgen, welcher von der Position des Tauchkerns Erdschlusslöschspule $L_{ASC}$ abhängt.

Bei einer aktiven Reststromkompensation kann es sinnvoll sein, genau auf eine Resonanz ($I_{pos}$ = $I_{res}$) abzustimmen.

Bei einer exakten Abstimmung entspricht die Netzimpedanz $Z_0$ = $R_0$, das heißt es liegt ein Maximum der Impedanz des Parallelschwingkreises ($L_{ASC}$, $R_o$, C) vor, und der Strom über die Fehlerstelle wird ohne Reststromkompensation minimal.

Auch bei exakter Abstimmung ist eine vollständige Kompensation des Fehlerstromes mit der Löschspule allein nicht möglich, da ohmsche Verluste durch die Anordnung nicht kompensiert werden können.

Diese Verluste können mittels aktiver Reststromkompensation, das heißt aktiver Stromeinspeisung mit einem Kompensationsstrom $I_{eci}(t)$, erfolgen.

An der Erdschlusslöschimpedanz $Z_0$ tritt eine komplexe Verlagerungsspannung $U_0$ auf und durch die Netzimpedanz $Z_0$ fließt ein Verlagerungsstrom $I_0$.

Der Unsymmetrie-Strom $I_u$, der Strom durch Netzimpedanz $Z_0$ und der Kompensations- bzw. Verlagerungsstrom $I_{eci}$ fließen am Sternpunkt des Dreiphasennetzes zusammen.

**Fig. 2** zeigt Beispiele für eine Ortskurve N3 der Verlagerungsspannung $U_0$ und Auslöseschwellen N1, N2 bei der Überwachung einer Sternpunktspannung.

Mit Schwelle N1 wird ein Auslösekriterium basierend auf Änderung des Absolutwertes der Verlagerungsspannung $U_0$ dargestellt und N2 kennzeichnet ein Auslösekriterium basierend auf der vektoriellen Änderung der Verlagerungsspannung $U_0$ für eine Neukompensation des Netzes nach dem Stand der Technik.

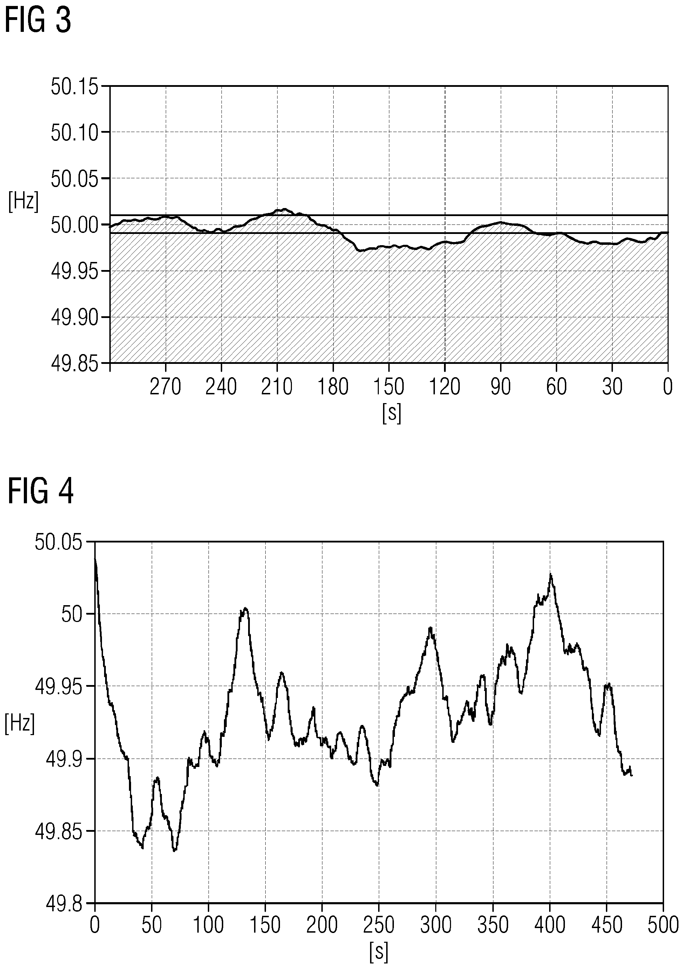

**Fig. 3** zeigt ein erstes Beispiel für den Frequenzverlauf eines Dreiphasennetzes über die Zeit.

Es ist eine Moment-Aufnahme des, in der Regel sehr stabilen europäischen UCTE-Netzes dargestellt, bei welchem die Frequenzänderung innerhalb von fünf Minuten etwa 30 mHz beträgt.

**Fig. 4** zeigt ein zweites Beispiel für den Frequenzverlauf eines Dreiphasennetzes über die Zeit.

Es ist eine Moment-Aufnahme eines australischen Netzes dargestellt, bei welchem die Frequenzänderung innerhalb von fünf Minuten etwa 200 mHz beträgt.

Im Vergleich zu Fig. 3 ist erkennbar, dass das australische Netz deutlich mehr in der Frequenz schwankt.

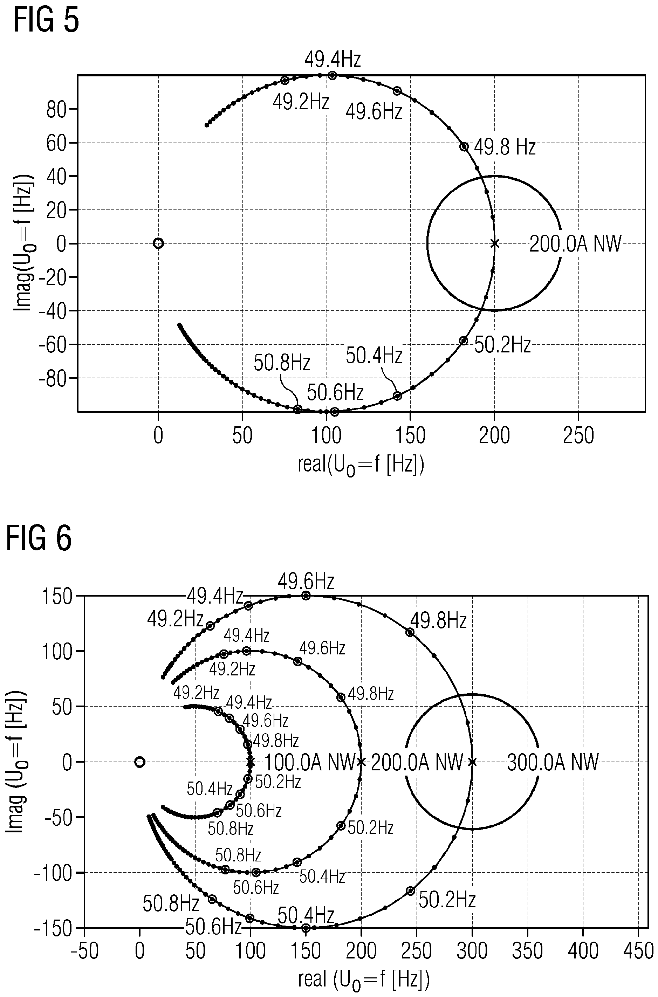

**Fig. 5** zeigt ein erstes Beispiel für eine Ortskurve eines Dreiphasennetzes in einem 200.0A-Netz mit eingezeichnetem Kreis als Auslösekriterium.

Bei einem Dämpfungsstrom $I_D$ von 5 A kann eine Frequenzänderung von ca. 130mHz eine vektorielle Spannungsänderung von mehr als 20% verursachen und damit ist beispielsweise das Auslösekriterium in Form des entsprechenden Kreisradius in der Figur erfüllt.

Berechnung der Netzadmittanz $Y_o$ in Abhängigkeit der Frequenz:

$$Y_o = \frac{1}{Z_o}$$

$$R_o = \frac{V_{nom}}{I_d}$$

$$Y_{o(f)} = \underbrace{\frac{1}{R_o}}_{Verluste} + j \cdot \underbrace{\left( w_{(f)} \cdot C - \frac{1}{w_{(f)} L_{ASC}} \right)}_{Verstimmung}$$

$$U_{nom} \cdot Y_{o(f)} = U_{nom} \cdot \frac{1}{R_o} + j \cdot \left( U_{nom} \cdot w_{(f)} \cdot C - \frac{U_{nom}}{w_{(f)} L_{ASC}} \right)$$

$$U_{nom} \cdot Y_{o(f)} = I_d + j \cdot \left( U_{nom} \cdot \frac{w_{(f)}}{w_{(f50)}} \cdot w_{(f50)} \cdot C - \frac{U_{nom}}{\frac{w_{(f)}}{w_{(f50)}} \cdot w_{(f50)} \cdot L_{ASC}} \right)$$

$$k_f = \frac{w_{(f)}}{w_{(f50)}}$$

$$Y_{o(f)} = \frac{1}{U_{nom}} \cdot \left( I_d + j \cdot \left( \underbrace{k_f \cdot I_{res(f50)} - \frac{1}{k_f} \cdot I_{pos(f50)}}_{I_{v(f)}} \right) \right)$$

Wobei eine nominelle Spannung $U_{nom}$ die Strangspannung ist.

Eine Kreisfrequenz $w_{(f)}$ bezieht sich auf die aktuelle Netzfrequenz, welche eine Abweichung gegenüber der nominellen Netzfrequenz 50 Hz ausweisen kann, während sich eine Kreisfrequenz $w_{(f50)}$ auf die nominelle Netzfrequenz 50 Hz bezieht.

$$w_{(f)} = 2 \cdot \pi \cdot f$$

Ein Gewichtsfaktor $k_f$ setzt die aktuelle Frequenz f in ein Verhältnis zur Nominellen Frequenz f50.

Die relevante Frequenzänderung entspricht der Differenz der aktuellen Frequenz und der Frequenz während des Abstimmvorganges.

In den obigen Zusammenhängen wurde die Netzfrequenz während eines Abstimmvorgang mit 50 Hz angenommen, was durch den als Index "f50" zum Ausdruck kommen soll.

Betrachtungen sind auch für Netze mit anderer Nominalfrequenz gültig, wie beispielsweise 60 Hz.

Nachdem bei jedem Abstimmvorgang die Netzparameter berechnet werden, inklusive der Unsymmetrie-Impedanz $Z_u$, sind die Parameter des Parallelschwingkreises $Z_o$, gebildet aus der Induktivität der Erdschlusslöschspule $L_{ASC}$, den Leitungskapazitäten $C$ und den gesamten Netzverlusten $R_o$ mehr oder weniger genau bekannt.

Zusätzliche externe Induktivitäten, wie Fixspulen oder dezentrale Erdschlusslöschspulen, können durch das bekannte Mehrfrequenzverfahren erkannt werden.

Ferner ist eine parametrische Berücksichtigung von zusätzlichen Induktivitäten möglich, wie eine Festspule mit einem Wert bei einer Nominalfrequenz und einem Schaltzustand.

Bei Berechnung der Netzparameter über eine Spulenverstellung bzw. 50Hz Stromeinspeisung kann nur die Verstimmung $I_v$ ermittelt werden, die Rückrechnung auf die Netzgröße bei Nominal- bzw. Resonanz-Frequenz $I_{res}$ erfolgt über die gemessene Spulenposition $I_{pos}$ mit $I_{res} = I_{pos} - I_v$

Die Netzfrequenz wird wiederholt gemessen, beispielsweise anhand einer Referenzspannungsmessung zwischen zwei Phasen. Die Netzparameter werden auf die gemessene Frequenz bezogen.

Nach dem Abstimmvorgang wird die Verlagerungsspannung $U_{0,ref}$ gesichert, und als Bezugsgröße für die vektorielle Differenzbildung bei der aktuellen Frequenz herangezogen.

Dieser Messwert kann mit oder ohne zusätzliche Filter erfasst werden, oder auch parametrisch anhand der ermittelten Netzparameter.

Die Referenz-Verlagerungsspannung $U_{0,ref}$ kann nun ebenfalls über die Netzparameter auf die aktuell gemessene Netzfrequenz bezogen werden, um eine frequenzabhängige Auslösung und Kompensation zu erreichen.

Durch die beschriebenen Zusammenhänge kann das erfindungsgemäße Verfahren zur Überwachung eines kompensiert betriebenen Drehstromnetzes auf eine Abstimmungsänderung der Erdschlusslöschspule durch folgende Verfahrens-Schritte zusammengefasst werden:

- für einen abgestimmten Zustand werden Referenz-Netzparameter und eine Referenz-Netzfrequenz ermittelt,
- für einen aktuellen Zustand wird eine aktuelle Netzfrequenz ermittelt,
- eine Referenz-Verlagerungsspannung, wird mithilfe der Referenz-Netzparameter für die aktuelle Netzfrequenz bestimmt,
- eine aktuelle Verlagerungsspannung, wird bei der aktuellen Netzfrequenz bestimmt,
- eine Differenz-Größe wird aus der Referenz- Verlagerungsspannung und der aktuellen Verlagerungsspannung mittels des Betrags einer vektoriellen Differenz bestimmt, aus welcher bei Überschreiten eines vorbestimmten Grenzwerts eine Abstimmungsänderung erkannt wird und geänderte Netzparameter ermittelt werden.

Die vorherigen Schritte können wiederholt ausgeführt werden, wobei die Bestimmung der geänderten Netzparameter zeitverzögert erfolgt, falls die Differenz-Größe über einen vorbestimmten Zeitraum hinweg durchgehend den vorbestimmten Grenzwert überschreitet.

Die Berechnung der Referenz-Kenngröße bei der aktuellen Frequenz $f$ kann beispielsweise aus den Netzparametern des vereinfachten Nullersatzschaltbildes gemäß der Fig. 1 erfolgen.

Die Netzimpedanz $Z_{o(f)}$ und die Unsymmetrie-Impdanz $Z_{u(f)}$ kann frequenzabhängig sein.

$$Z_{o(f)} = \frac{1}{Y_{o(f)}}$$

$$U_{o\,(f)REFERENZ} = \left( \frac{E_u}{Z_{o(f)} + Z_{u(f)}} + I_{eci} \cdot \frac{Z_{u(f)}}{Z_{o(f)} + Z_{u(f)}} \right) . Z_{o(f)}$$

Die ermittelte Referenz-Kenngröße kann somit zur Differenzbildung mit der gemessenen Verlagerungsspannung herangezogen werden.

Die Differenz-Größe kann optional zusätzlich gefiltert werden, beispielsweise mittels Mittelwertbildung oder linearen oder auch nichtlinearen Filtern.

**Fig. 6** zeigt ein zweites Beispiel für Ortskurven eines Dreiphasennetzes in einem 100.0 A-, 200.0 A- und 300.0 A-Netz mit eingezeichnetem Kreis als Auslösekriterium für das letztere Netz.

Bei einem Dämpfungsstrom $I_D$ von 5 A kann eine Frequenzänderung von ca. 90 mHz eine vektorielle Spannungsänderung von mehr als 20% verursachen und damit ist beispielweise das Auslösekriterium in Form des entsprechenden Kreisradius in der Figur erfüllt.

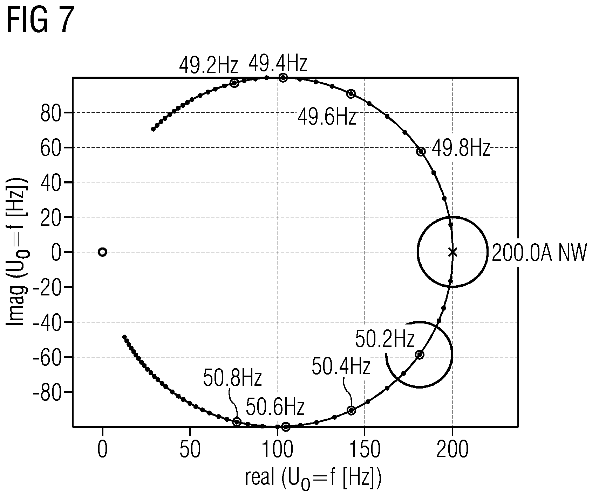

**Fig. 7** zeigt ein drittes Beispiel für eine Ortskurve eines Dreiphasennetzes in einem 200.0 A-Netz.

Es sind zwei Kreise erkennbar, ein Kreis mit dem Zentrum bei 50.0 Hz und ein Kreis mit dem Zentrum bei 50.2 Hz, welche eine frequenzabhängige Anpassung des Auslösekreises erlauben.

Mit anderen Worten wird das Auslösekriterium für eine neuerliche Ermittlung der Netzparameter frequenzabhängig definiert.

Solange das Auslösekriterium durch die aktuelle Verlagerungsspannung nicht überschritten ist, wird die Induktivität der Erdlöschspule $L_{ASC}$ konstant gehalten.

**Bezugszeichenliste:**

| | |
|---|---|
| $C$ | Netzkapazität |
| $E_u$ | treibende Unsymmetriespannung |
| $I_d$ | Dämpfungsstrom |
| $I_{eci}$ | Kompensations-Strom (ECI, engl. "enhanced current injection") |
| $I_{pos}$ | Strom bzgl. Spulen-Kern-Position |
| $I_{res}$ | Resonanz-Strom |
| $I_u$ | Unsymmetriestrom |
| $I_v$ | Verstimmungs-Strom (Iv=Ipos-Ires) |

| $L_{ASC}$ | Induktivität der Erdlöschspule-Spule (ASC, engl. "arc suppresion coil") |
|---|---|
| N1, N2 | Grenzwert |
| N3 | Ortskurve der Verlagerungsspannung $U_0$ |
| NW | Netz, engl. "network" |
| $R_0$ | Ersatzwiderstand |
| $U_0$, $U_{0,res}$ | Verlagerungsspannung, Nullspannung |
| $Z_0$ | Impedanz Erdlöschspule |
| $Z_u$ | Impedanz Unsymmetrie |

**Patentansprüche**

1. Verfahren zur Überwachung eines kompensiert betriebenen Drehstromnetzes auf eine Abstimmungsänderung der Erdschlusslöschspule,

   wobei für einen abgestimmten Zustand Referenz-Netzparameter und eine Referenz-Netzfrequenz ermittelt werden,
   und für einen aktuellen Zustand eine aktuelle Netzfrequenz ermittelt wird,
   und eine Referenz-Kenngröße, welche zu einer Verlagerungsspannung proportional ist, mithilfe der Referenz-Netzparameter für die aktuelle Netzfrequenz bestimmt wird, und eine aktuelle Kenngröße, welche zu einer Verlagerungsspannung proportional ist, bei der aktuellen Netzfrequenz bestimmt wird,
   und eine Differenz-Größe aus der Referenz-Kenngröße und der aktuellen Kenngröße bestimmt wird, aus welcher bei Überschreiten eines vorbestimmten Grenzwerts eine Abstimmungsänderung erkannt wird und geänderte Netzparameter ermittelt werden.

2. Verfahren nach dem vorhergehenden Anspruch, wobei die Referenz-Kenngröße und die aktuelle Kenngröße jeweils eine Verlagerungsspannung sind.

3. Verfahren nach einem der vorhergehenden Ansprüche, wobei für die Differenz-Größe der Betrag einer vektoriellen Differenz herangezogen wird.

4. Verfahren nach einem der vorhergehenden Ansprüche, wobei die Bestimmung der geänderten Netzparameter zeitverzögert erfolgt, falls die Differenz-Größe über einen vorbestimmten Zeitraum hinweg durchgehend den vorbestimmten Grenzwert überschreitet.

5. Verfahren nach einem der vorhergehenden Ansprüche, wobei die Netzparameter zumindest eine Induktivität der Erdschlusslöschspule und zumindest eine Leitungskapazität umfassen.

6. Vorrichtung zur Überwachung eines kompensiert betriebenen Drehstromnetzes auf eine Abstimmungsänderung der Erdschlusslöschspule, umfassend eine Messvorrichtung zur Erfassung einer Verlagerungsspannung und einer Netzfrequenz, eine Rechenvorrichtung zur Bestimmung von Netzparametern, wobei die Vorrichtung dazu eingerichtet ist, das Verfahren nach einem der vorhergehenden Ansprüche auszuführen.

**Claims**

1. A method for monitoring a three-phase power network operated in a compensated manner for a tuning change of the arc suppression coil,

   wherein reference network parameters and a reference network frequency are ascertained for a tuned state, and a current network frequency for a current state is ascertained, and
   a reference characteristic variable is determined, which is proportional to a displacement voltage, using the reference network parameters for the current network frequency, and
   a current characteristic variable is determined, which is proportional to a displacement voltage, at the current network frequency, and
   a differential variable is determined from the reference characteristic variable and the current characteristic variable, from which a tuning change is identified when a predetermined threshold value is exceeded, and modified network parameters are ascertained.

**2.** The method according to the preceding claim, wherein each of the reference characteristic variable and the current characteristic variable is a displacement voltage.

**3.** The method according to any one of the preceding claims, wherein the magnitude of a vectorial difference is used for the differential variable.

**4.** The method according to any one of the preceding claims, wherein the determination of the modified network parameters is time-delayed if the differential variable continuously exceeds the predetermined threshold value over a predetermined period of time.

**5.** The method according to any one of the preceding claims, wherein the network parameters comprise at least one inductance of the arc suppression coil and at least one line capacitance.

**6.** A device for monitoring a three-phase network operated in a compensated manner for a tuning change of an arc suppression coil, comprising

a measuring device for ascertaining a displacement voltage and a network frequency,
a computing device for determining network parameters,

wherein the device is configured to carry out the method according to one of the preceding claims.

**Revendications**

**1.** Procédé de surveillance d'un réseau triphasé à fonctionnement compensé pour détecter une variation de syntonisation de la bobine d'extinction,

dans lequel, pour un état syntonisé, des paramètres de réseau de référence et une fréquence de réseau de référence on sont déterminées,
et, pour un état actuel, une fréquence de réseau actuelle est déterminée,
et une grandeur caractéristique de référence, qui est proportionnelle à une tension de décalage, est déterminée à l'aide des paramètres de réseau de référence pour la fréquence de réseau actuelle, et une grandeur caractéristique actuelle, qui est proportionnelle à une tension de décalage, est déterminée à la fréquence de réseau actuelle,
et une grandeur différentielle est déterminée à partir de la grandeur caractéristique de référence et de la grandeur caractéristique actuelle, à partir de laquelle, en cas de dépassement d'une valeur limite prédéterminée, une modification de l'accord est détectée et des paramètres de réseau modifiés sont déterminés.

**2.** Procédé selon la revendication précédente, dans lequel la grandeur caractéristique de référence et la grandeur caractéristique actuelle sont chacune une tension de décalage.

**3.** Procédé selon l'une des revendications précédentes, dans lequel on utilise pour la grandeur de différence la valeur d'une différence vectorielle.

**4.** Procédé selon l'une des revendications précédentes, dans lequel la détermination des paramètres de réseau modifiés s'effectue avec un retard dans le cas où la grandeur différentielle dépasse continuellement la valeur limite prédéfinie pendant une période prédéfinie.

**5.** Procédé selon l'une des revendications précédentes, dans lequel les paramètres de réseau comprennent au moins une inductance de la bobine d'extinction et au moins une capacité de conduction.

**6.** Dispositif de surveillance d'un réseau triphasé à fonctionnement compensé pour détecter une variation de syntonisation de la bobine d'extinction, comprenant un dispositif de mesure pour détecter une tension de décalage et une fréquence de réseau, un dispositif de calcul pour déterminer des paramètres de réseau, le dispositif étant conçu de façon à mettre en œuvre le procédé selon l'une des revendications précédentes.

FIG 1

FIG 2

FIG 3

FIG 4

FIG 5

FIG 6

# FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3643391 A1